Europäisches Patentamt

European Patent Office

Office européen des brevets

(11) Publication number: **0 503 621 A1**

## EUROPEAN PATENT APPLICATION

(21) Application number: **92104270.1**

(22) Date of filing: **12.03.92**

(51) Int. Cl.⁵: **G03F 1/00, B41C 1/10**

(30) Priority: **12.03.91 JP 46771/91**

(43) Date of publication of application:
**16.09.92 Bulletin 92/38**

(84) Designated Contracting States:
**DE FR GB IT**

(71) Applicant: **NIPPON PAINT CO., LTD.**
**2-1-2, Oyodokita Kita-ku**
**Osaka-shi Osaka 530(JP)**

(72) Inventor: **Hase, Takakazu**
**7-9, Kitashowa-cho**
**Nishinomiya-shi, Hoyogo(JP)**
Inventor: **Arimatsu, Seiji**
**1-45-6, Kuzuhanoda**
**Hirakata-shi, Osaka(JP)**
Inventor: **Kimoto, Koichi**
**1-12-10, Higashikori**
**Hirakata-shi, Osaka(JP)**

(74) Representative: **Füchsle, Klaus, Dipl.-Ing. et al**
**Hoffmann . Eitle & Partner Patentanwälte**
**Arabellastrasse 4**
**W-8000 München 81(DE)**

(54) **Direct lithographic plate making method and its apparatus using an ink jet system.**

(57) A direct lithographic plate making method and apparatus using an ink jet system in which a lithographic printing plate is produced forming an image area on the plate material (2), by first feeding the plate material (2) to the plate making apparatus in a plate material feeding section, then forming ink images which correspond to image information in an image output section of ink jet system directly on this plate material surface, and finally conducting at least exposure treatment in an image exposure section onto a plate material surface.

*Fig.21*

(Plate material)
Substrate for PS plate
2

(Printing)
Photo-curing ink
2

(Exposure)
UV
Visual

Lithographic plate
2

## FIELD OF THE PRESENT INVENTION

The present invention relates to direct lithographic plate making method and its apparatus by use of an ink jet system.

Prior Art

In general, the offset printing by use of lithography is widely used in various printing materials ranging from newspapers, general commercial printing materials and the like, because it permits high quality printing compared with other printing methods. And, PS plates (presensitized plates) are widely used, on which a substrate surface consisting of aluminum, zinc or the like as its raw material is preformed with a photosensitive layer, as a printing plate for the offset printing. With the conventional plate making method which uses such PS plates, normally, lithographic plate is produced in such a procedure that, after a film on which an image is expressed is set on the surface of photosensitive layer, light or UV ray is irradiated onto the photosensitive layer through the film, then makes it soluble or insoluble the irradiated area on which the light or UV ray is irradiated by a photochemical reaction and the like, and the soluble area is eliminated by conducting a development treatment to the photosensitive layer, then an image area is formed on the printing plate. In this case, as a photosensitive material which is made available as raw material for the photosensitive layer, for example, a negative-type diazo photosensitive material which is made insoluble in a developer through an exposure treatment (i.e., a mixture of alkaline soluble acrylic resin and condensate which consists of diazodiphenylamine and paraformaldehyde), or a positive-type diazo photosensitive material which can be made soluble in a developer through an exposure treatment (i.e., a mixture of phenol novolac resin and sulfonate of naphthoquinone diazide) are widely used. In addition, other than those PS plates using such diazo-type photosensitive material, a PS plate is also used which has an image layer consisting of a photopolymerizable composition which can be made insoluble in a developer through the exposure treatment (hereinafter called a photopolymerization-type PS plate). This photopolymerization-type PS plate has advantages of higher printing durability and sensitivity for lithography, thus attracting remarkable attention recently.

By the way, with the recent advent of a phototypesetting / pagination system capable of easily producing an original manuscript, a scanner which allows images to be read directly or the like has come to be in use, along with the progress of computers; digitization of image information is rapidly in progress from with respect to processes copy block making to plate making, which are those to be done prior to the real printing process. When the plate making is done based on the image information thus digitized, however, in case of conventional method, a film is made to express images according to the image information and an image area is formed on a printing plate through exposure, development treatments further using this film, which is very inefficient. Therefore, a direct plate making system has been proposed, which directly forms an image area on the printing plate without using film based on digital image information transmitted from computers, facsimiles etc.

As one of the direct plate making systems, a laser plate making system has conventionally been known, and this system forms an image area on a printing plate with the help of chemical or physical change caused when the laser light is irradiated by scanning the surface of PS plate, wipe-on plate, electrophotographic plate, and the like which is switched ON/OFF according to the digital image information

However, with such a laser plate making system, the apparatus or the system tends to become a large scale or expensive one. Because, it requires a laser device which generates a laser beam, complex optical, driving and scanning system which modulates a mono-laser beam output from the laser device according to the image information and guides the modulated beam onto the surface of the plate.

Although higher sensitivity, resolution, and printing durability are generally required for the plate making system or for the lithographic plate made thereby, there seems to be no system which sufficiently retains such factors for the conventional laser plate making system or the printing plate produced therefrom. For example, with a laser plate making System which adopts a photosensitive material consisting of silver halide, there are such problems that printing durability is low for lithography, and plate itself is expensive despite higher sensitivity and resolution. Although an electophotographic laser plate making system which forms a toner image onto an organic photoconductive material (photosensitive material) is proposed, this system has a complicated image forming process with insufficient printing durability and resolution on lithography. In addition to this, though the laser plate making system which uses photopolymerization-type lithography as a printing plate is proposed, this system has insufficient sensitivity despite its merit of sufficient printing durability, resolution and cost, making it a very uneconomical system which requires a laser with higher output.

Besides the laser plate making system, a direct plate making system which uses a thermal printing apparatus adopting a thermal head, etc. (hereinafter called a thermosensitive plate making system) has likewise been known. With this system, a thermal head is scanned according to the image information on the surface of a thermosensitive recording layer which is formed on the surface of water-resistant substrate, and then an image area is formed on the printing plate with physical or chemical change in an area to which heat is applied. With this thermosensitive lithographic system, it has such advantages that the plate making apparatus can be made smaller and that the process becomes simple.

However, with the thermosensitive plate making system, the temperature transmitted from the thermal head to a thermosensitive recording surface is transmitted to a surrounding area where no contact was made with the thermal head giving change in temperature also in this area, and the boundary between the printing area and non printing area does not become sharp, thereby rendering limit in its resolution. Furthermore, it has such an essential problem that a degree of modulation becomes extraordinarily larger between the images which is represented by digital image information input to the thermal head and which is represented by an image area actually formed on the substrate. Also, in general, with the other lithographic systems, printing durability is improved by hardening the image area through giving the heat energy, etc. on the surface of printing plate after forming the image area. But, with the thermosensitive lithographic system forming the image area by thermal treatment, it is impossible to improve the printing durability by this method. Therefore, it is difficult to retain sufficient resolution, sensitivity, and printing durability with the thermosensitive plate making system.

## SUMMARY OF THE INVENTION

The present invention was made to solve the conventional problems as above-mentioned, and the object is to supply a simple and yet inexpensive direct plate making system of a small scale, being capable of producing printing plate equipped with higher resolution and printing durability allowing a sharp image area to be formed directly on the plate material based on digital image information transmitted from computer, facsimile and the like, without use of film and even when the plate material is not made of special high sensitivity.

In order to solve the above-mentioned object, the first invention is to provide direct lithographic plate making method using an ink jet system, comprising steps of; feeding a plate material to a plate making apparatus, forming an ink image corresponding to the image information directly onto the surface of plate material, and forming an image area on the plate material by exposing the surface of plate material.

The second invention is to provide lithographic plate making apparatus, comprising; plate feeding means for feeding a plate material, image output means of an ink jet system for forming an ink image directly onto the surface of plate material based on image information, and image area forming means for forming an image area on the plate material by exposing the surface of plate material on which the ink image has been formed.

## BRIEF DESCRIPTION OF THE DRAWINGS

Fig. 1 shows a block diagram of schematic system configuration for a plate making apparatus concerned with the present invention.

Fig. 2 shows a system block diagram for a plate making apparatus illustrating the first embodiment of the present invention.

Fig. 3 shows an explanation drawing of a side elevational view for a plate making apparatus illustrating the first embodiment of the present invention.

Fig. 4 shows a flow chart of main routines for lithographic plate production procedures used in the plate making apparatus as shown in Fig. 2 to Fig. 3.

Fig. 5 shows a flow chart of printing routine for lithographic plate production procedures used in the plate making apparatus as shown in Fig. 2 to Fig. 3.

Fig. 6 shows a flow chart of exposure routine for lithographic plate production procedures used in the plate making apparatus as shown in Fig. 2 to Fig. 3.

Fig. 7 shows a flow chart of development routine for lithographic plate production procedures used in the plate making apparatus as shown in Fig. 2 to Fig. 3.

Fig. 8 shows an explanation drawing of a side elevational view for a plate feeding area to transport a plate by use of a vacuum head.

Fig. 9 shows an explanation drawing of a side elevational view for a plate feeding area to transport a plate by use of rolls.

Fig. 10 shows a perspective explanation drawing of transport roll for the plate making apparatus.

Fig. 11 shows a typical illustration of an ink jet system of drop on demand type.

Fig. 12 shows a typical illustration of an ink jet system of continuous type.

Fig. 13 shows a typical illustration of an ink jet head of fixed type.

Fig. 14 (a) to (e) show illustrations of nozzle arrangement of ink jet head of fixed type, respectively.

Fig. 15 shows an illustration of the number of dots on one line in relation to the nozzle arrangement when the nozzle arrangement is not inclined to an advancing direction of plate material.

Fig. 16 shows an illustration of the number of dots on one line in relation to the nozzle arrangement when the nozzle arrangement is inclined to an advancing direction of plate material.

Fig. 17 shows a typical illustration of an ink jet system of scanning type.

Fig. 18 (a) to (e) show illustrations of the example for nozzle arrangement of the ink jet head of scanning type, respectively.

Fig. 19 shows a plate making process when a positive type PS plate is used as a plate material and photoabsorptive water-based ink as an ink composition.

Fig. 20 shows a plate making process when a photopoly merization-type PS plate is used as a plate material and water-based ink containing a water soluble polymer which becomes an oxygen shielding layer is used as an ink composition.

Fig. 21 shows a plate making process when a substrate for PS plate is used as a plate material, and photocuring ink composition is used as an ink composition.

Fig. 22 shows an explanation drawing of a side elevational view for a plate making apparatus as shown in the second embodiment of the present invention.

Fig. 23 (a) shows an explanation drawing of a side elevational view for a plate making apparatus as shown in the third embodiment of the present invention, and (b) shows an illustration of an enlarged view of gripping area for the above-mentioned plate making apparatus.

Fig. 24 shows an explanation drawing of a side elevational view for a plate making apparatus as shown in the fourth embodiment of the present invention.

Fig. 25 shows an explanation drawing of a side elevational view for a plate making apparatus as shown in the fifth embodiment of the present invention.

## DETAILED DESCRIPTION OF PREFERRED EMBODIMENT

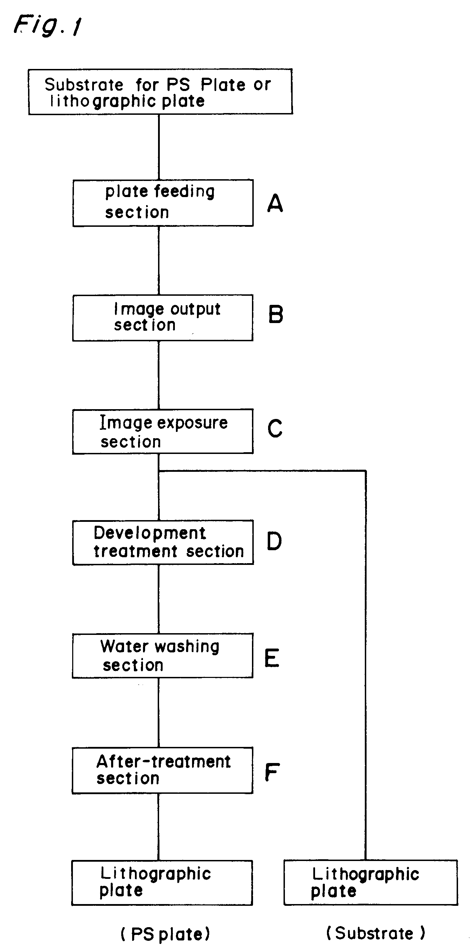

The embodiment of the present invention concretely follows below. Fig. 1 shows a schematic system configuration of the direct lithographic plate making apparatus concerned with the present invention. As shown in Fig. 1, the lithographic plate making apparatus which produces lithographic printing plates (hereinafter simply called "printing plate") from plate materials is fundamentally provided with a plate feeding section A, image output section B, image exposure section C, development treatment section D, water washing section E, and after-treatment section F. Here, as plate material, PS plate or a substrate without photosensitive layer (hereinafter simply called "substrate") is used as will be explained later. Fundamental functions for each section from A to F are explained as follows.

(1) The plate feeding area A feeds the PS plate or substrate one by one to the image output section B.

(2) The image output area B forms (hereinafter called "printing") an ink image corresponding to digital image information by injecting ink composition by the ink jet system onto the surface of PS plate or substrate. Based on the ink jet system, the plate making apparatus is made compact with ease of maintenance, because ink image formation is achieved at a comparatively high speed and does not require any complicated optical system.

(3) The image exposure section C conducts an exposure treatment on the surface of the PS plate or substrate on which ink images are formed, by using a light source having a emission spectrum which complies with the properties of a photosensitive layer and ink composition. As will be described later, when the plate material is a PS plate, an area at which ink images are not formed should be a soluble area (this area is not necessarily photosensitive) to the developer, and thereby an area where the ink image is formed should be an insoluble area. Likewise, when the plate material is a substrate, the photocuring ink is hardened through an exposure treatment and then directly gives rise to an image area. As a light source, for example, high pressure mercury lamp, metal halide lamp, Xenon lamp, etc. can be used. In case the plate material is a substrate, the printing plate is completed in the above process, and treatments like a following development treatment section, water washing section, and after-treatment section are not necessary.

(4) The development treatment section conducts a developing treatment to a PS plate, at which an exposure treatment was conducted, with a developer which complies with the characteristics of the photosensitive layer. With this development, an area corresponding to a soluble area of photosensitive layer, i.e., nonimage area can be eliminated.

(5) Water washing section E eliminates residual developer remained on the PS plate by washing with water. By the processes above, an image area at which oil-based ink is adhered to the PS plate when printing, and the non-image area at which the ink is not adhered to the plate are formed.

(6) The after-treatment section F conducts a hydrophilic treatment, a burning treatment and the like in order to give further desensitization to the nonimage area to which printing ink (oil based ink) should not be adhered, or to further improve the printing durability of the image area to which printing ink adheres.

In addition, if necessary, a drying section may be provided in order to dry the ink images between the image output section B and the image exposure section C.

<The First Embodiment>

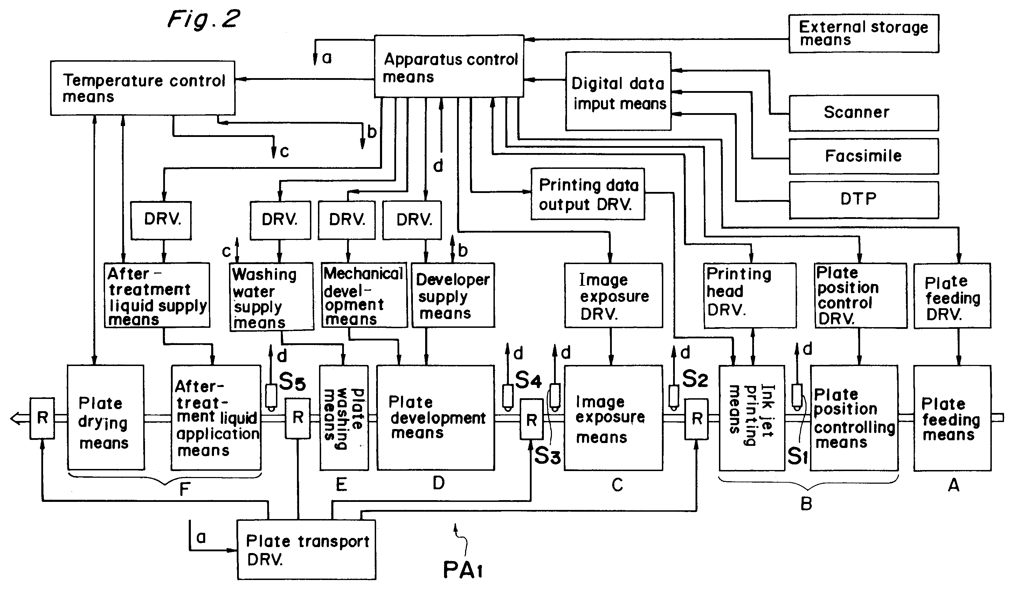

Fig. 2 shows a system configuration which contains a control system of a plate making apparatus PA1 as used when the plate material is mainly a PS plate. As shown in Fig. 2, in the plate feeding section A, plate feeding means which sends out stocked PS plates one by one to the image output section B, and a plate feeding driver which drives it is provided. The plate feeding driver is so designed that its movement is controlled by apparatus control means. The apparatus control means is overall control means for the plate making apparatus PA1 configured with a microcomputer.

In the image output section B, plate position control means which is driven by a plate position control driver and positions the PS plate upon printing, and an ink jet printing means which prints by injecting an ink composition onto the PS plate also equipped with a printing head driver and printing data output driver are provided. The functions for each plate position control driver, printing head driver, and printing data output driver are controlled by an apparatus control means, respectively.

In the image exposure section C, an image exposure means which conducts an exposure treatment to the PS plate, and an image exposure driver which drives it is provided. The image exposure driver is so designed that its movement is controlled by the apparatus control means.

In the development section D, a plate development means which conducts development to the PS plate, a developer supply means which supplies the developer, a driver for driving the same, a mechanical development means which mechanically eliminates an unnecessary photosensitive layer, and a driver for driving the same are provided. Both the above drivers are so designed that they are controlled by an apparatus control means, and the developer supply means is designed so that the temperature of developer is controlled by the temperature control means.

In the water washing section E, a water washing means which washes the PS plate, a washing water supply means which supplies washing water, and a driver for driving the same are provided. The driver is so designed that the movement is controlled by an apparatus control means, and also the washing water supply means is so designed that the water temperature is controlled by the temperature control means.

In the after-treatment section F, an after-treatment liquid coating means which applies after-treatment liquid to the PS plate, an after-treatment liquid supply means which supplies after-treatment liquid, a driver for driving the same, and a plate drying means are provided. The driver is so designed that its movement is controlled by an apparatus control means, and the after-treatment liquid supply means is designed so that the temperature of treatment liquid can be controlled by a temperature control means. Likewise, the plate drying means is so designed that its drying temperature is controlled by a temperature control means. The method for applying the treatment liquid may be either spraying or dipping type.

Furthermore, in a course of the processes from plate feeding to plate discharge, a plurality of plate transport means R driven by a plate transport driver is provided in order to transport the PS plates in a predetermined order. The plate transport driver is so designed that the movement is controlled by an apparatus control means. Likewise, at a predetermined position in transport line of the PS plate, position detection means S1 to S5 are provided in order to detect the front or rear end of the PS plate.

The apparatus control means is so designed that digital image data are transferred from a scanner, a facsimile, a DTP and the like through digital data input means. Likewise, the apparatus control means is provided with an external storage means which stores various data.

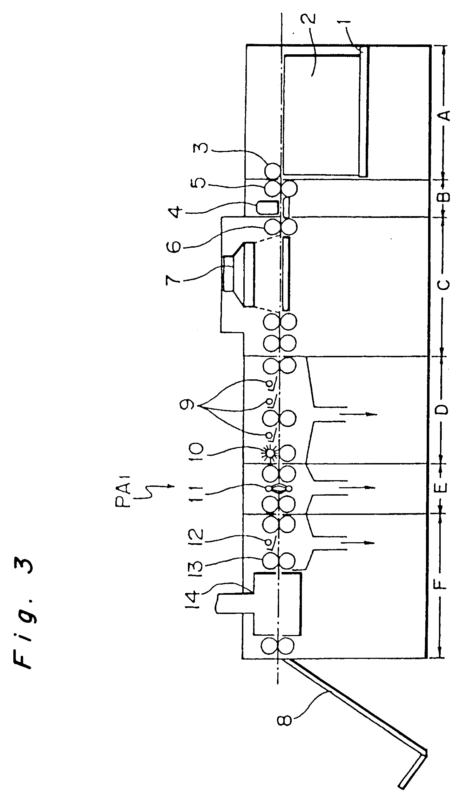

Fig. 3 shows a concrete structure of the plate making apparatus PA1. As shown in Fig. 3, in the plate making apparatus PA1, arrangement is made in a lengthwise direction (left-right direction in case of Fig. 3) from a plate feeding side end (as a right side end in case of Fig. 3) to the plate feeding section A, image output section B, image exposure section C, development treatment section D, water washing section E, and after-treatment section F. Basically, it is so designed that the PS plates are transported horizontally from the plate feeding section A up to the after-treatment section F, during which period a predetermined treatment can be made in each treatment area from B to F.

The plate feeding section A is so designed that the PS plate 2 loaded on the plate feeding section 1 is fed one by one by the plate feeding roll 3 to the image output section B. In this case, plate feeding section 1 and plate feeding roll 3 correspond to the plate feeding means shown in Fig. 2.

The image output section B is so designed that the ink image is formed (printed) on the surface of PS plate by injecting ink of a predetermined composition to the PS plate 2 which is the object to be printed from an ink jet head 4. In this case, upon printing, the position of PS plate 2 is controlled by the roll 5 for plate position control. Here, PS plate 2 is designed to be transported to the image exposure section C by the transport roll 6, but it may be so designed that the PS plate 2 is transported to the image exposure section C with only the plate position control roll 5, without providing the transport roll 6. In this case, the ink jet head 4, plate position control roll 5, and transport roll 6 correspond to the ink jet printing means, plate position control means, and plate transport means R, respectively.

The image exposure section C is so designed that a light suited to the ink composition or material of PS plate 2 is irradiated from the image exposure light source 7, and exposure treatment is conducted onto the PS plate 2. This exposure treatment, as will be explained later, converts an area where the ink image is not formed to a soluble layer to the developer, while an area where the ink image is formed is made an insoluble area. In this case, the image exposure light source 7 corresponds to the image exposure means shown in Fig. 2.

The development section D is so designed that the developer in accordance with the material of photosensitive layer is supplied to the PS plate 2 from a developer supply nozzle 9, and unnecessary photosensitive layer (soluble area) is swelled and/or dissolved. Then, the unnecessary photosensitive layer which was swelled and/or dissolved is mechanically removed by a rotary brush 10. In this case, the developer supply nozzle 9 and the rotary brush 10 respectively correspond to the developer supply means and mechanical development means shown in Fig. 2.

The water washing section E is so designed that washing water is supplied to the PS plate 2 from a water washing nozzle 11, and the developer remained on the PS plate 2 is washed off. In this case, the water washing nozzle 11 corresponds to the water washing means shown in Fig. 2.

The after-treatment section F is so designed that desensitization liquid is supplied to the PS plate 2 from an desensitization liquid nozzle 12, and also an excessive desensitization liquid on the PS plate 2 is removed by a removing roll 13 for excessive desensitization liquid. Likewise, a drying section 14 is provided so that solvent component in the desensitization liquid which is adhered to the surface of the PS plate will be evaporated. In this case, the desensitization liquid nozzle 12 and the elimination roll 13 for excessive desensitization liquid correspond to the after-treatment application means shown in Fig. 2, and the drying section 14 corresponds to the plate drying means shown in Fig. 2. In this case, a discharge section 8 is provided for taking out the PS plate 2 (printing plate) from the plate making apparatus.

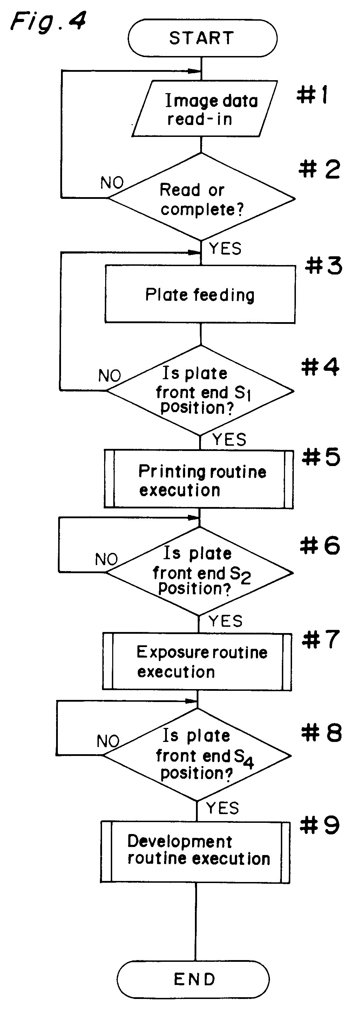

Description for production procedures of printing plate by use of the plate making apparatus PA1 follows below, referring basically to Fig. 1 to Fig. 3 in accordance with flow charts shown in Fig. 4 to Fig. 7 below: First of all, description follows below of the main routine as shown in Fig. 4. In Step #1, digitized image data are read in the apparatus control means. As image data, for example, graphic information transferred from a scanner for reading graphic images, the information containing characters which are typeset or paginated, image information transmitted by facsimiles, etc. are used. And, such image data are directly read in apparatus control means through digital data input means, or appropriately read in the apparatus control means from an external storage means after memorized or stored in an external storage means in advance.

Then, comparison/judgment is performed as to whether image data read-in has completed or not in Step #2, and, if the evaluation is judged that the read-in has not been completed (NO), Step #1 - Step #2 are repeatedly performed. On the other hand, if it is judged that the read-in has completed in the Step #2 (YES), namely, printing becomes standby, one blank PS plate 2 on the top of compiled plates loaded on a plate feeding base in the plate feeding section A is transferred to the image output area B in Step #3. Conventional positive PS plates, photopolymerization-type PS plates, and the like are used as PS plate 2.

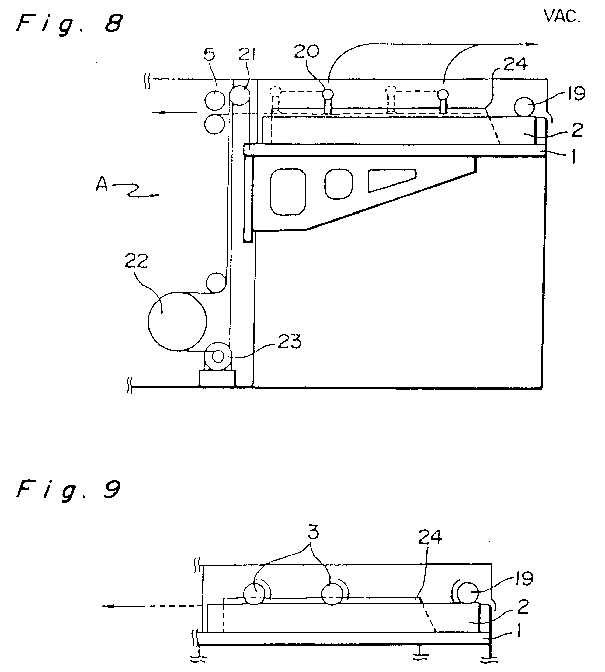

In Fig. 8, a concrete structure of the plate feeding section A is shown. In the plate feeding section A, a plate feeding base 1 (up/down lift) is designed to move up and down by a motor 23 through an up/down lift gear 21 and deacceleration gear 22. In this case, the deacceleration gear 22 has a function that decreases up/down movement on the plate feeding base 1 to the rotation of the motor 23 than the case to which the motor 23 and the plate feeding base 1 are directly connected. Therefore, for example, the number of rotation of the motor shaft can be set to about 30 rotations when the plate feeding base 1 is moved by 3 mm in an up/down direction. In this case, to move the plate feeding base 1 to 2 mm in an up/down direction, it may be acceptable to set the shaft rotation of motor 23 to 20 rotations. In this way, as the shaft rotation of the motor 23 to the movement of the plate feeding base 1 becomes greater, setting the detailed movement in an up/down direction of the plate feeding base 1 can be made possible. But, in this case, a balancing weight (not shown in the figure) is provided at a reverse side to the above-mentioned driving system from 21 to 23.

The PS plate 2 loaded on the plate feeding base is fed forward one by one (in a left-hand side in Fig. 8) by a plate feeding vacuum head 20 capable of moving in a forward/backward direction. In this case, when an intermediate paper (not shown in the figure) is inserted between each loaded PS plate 2, this intermediate paper is discharged backward (not shown in the figure) by an intermediate paper discharge roll 19. In this case, the intermediate paper may of course be discharged by a vacuum head system. Likewise, the position of a left/right direction (in a width direction) of the PS plate 2 is limited by a left/right position adjusting plate 24. In this case, instead of the plate feeding vacuum head 20, the PS plate 2 may be fed forward by a plate feeding roll as shown in Fig. 9. In the plate making apparatus PA1 shown in Fig. 3, it is so designed that the PS plate 2 is fed forward by a plate feeding roll 3 instead of the vacuum head.

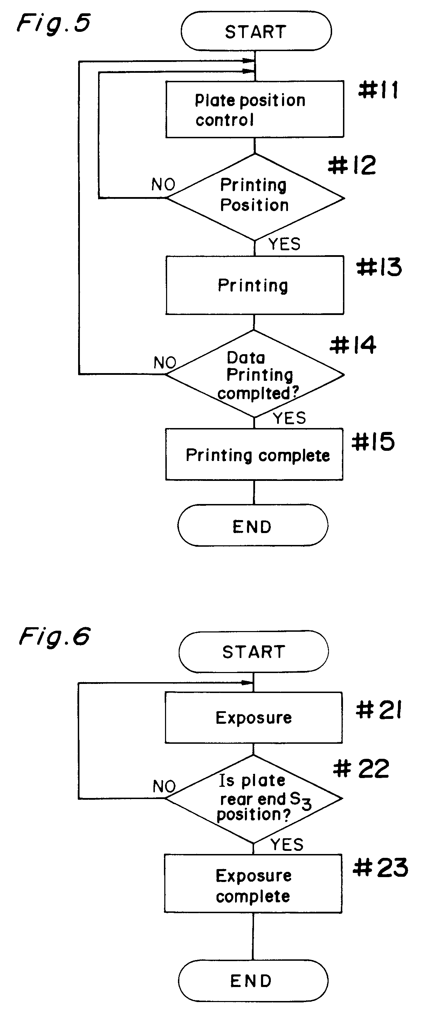

In step #4, whether the front end of the PS plate 2 fed to the image output area B is detected or not by first position detecting means S1 which is positioned directly downward of a plate position control roll 5, namely, whether this PS plate 2 has reached the position at which the position can be controlled by a plate position control roll 5 (plate position control means) or not is compared / judged, and Step #3 - Step #4 are repeatedly performed if judged to be not detected (NO). On the other hand, in Step #4, if the front end of the PS plate 2 is judged to be detected (YES), printing routine (Fig. 5) as will be described later in Step #5 is triggered and performed, and then printing is performed on the surface of the PS plate 2 by an ink jet system (ink images are formed).

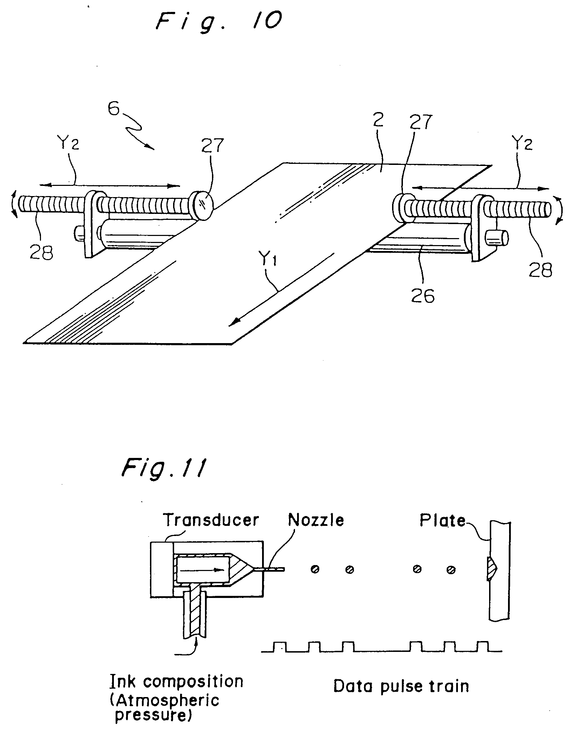

In Step #6, whether the front end of the PS plate 2 fed from the image output section B by a transport roll 6 (plate transport means R) is detected or not by the second plate position detecting means arranged directly upward of the image exposure means is compared / judged, and if judged to be not detected (NO), this Step #6 is repeatedly performed. As shown in Fig. 10, it is so designed that the PS plate 2 is fed in an arrow marked Y1 direction (forward) by inserting the PS plate 2 between the transport roll 6 (transport means R), transport backup roll 26, and plate pressing roll 27, and then by rotating the backup roll 26. Likewise, the plate pressing roll 27 is so designed that the position of both arrow marked Y2 directions (width direction, or left/right direction) can be changed by rotating a shaft 28 which has slots around its circumference. Therefore, it is so designed that the PS plate 2 can be fed without disturbing the ink images, in accordance with the width of the PS plate 2, by adjusting the position in a Y2 direction of the plate pressing roll 27, and also by pressing the neighborhood of both end area in a width direction of the PS plate 2.

In Step #6, if the front end of the PS plate 2 is judged to be detected (YES) by the second plate position detecting means S2, an exposure routine (Fig. 6) is triggered and performed as will be described later in Step #7, and then exposure treatment is performed on the PS plate 2. In this case, this exposure routine may be triggered during a course of performing the printing routine.

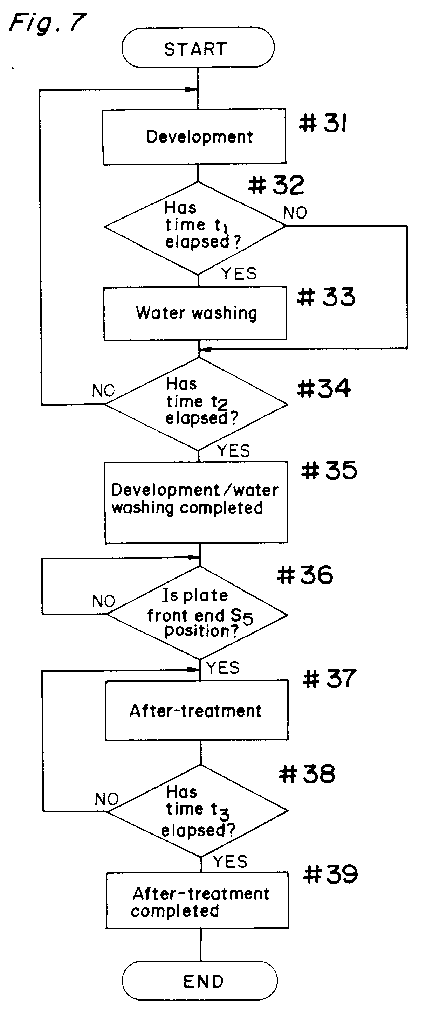

In Step #8, the front end of the PS plate 2 fed from the image exposure section C is compared / judged to be detected or not by fourth plate position detecting means S4 which is arranged directly upward of the developer liquid supply nozzle 9 (plate developing means), and if judged to be not detected (NO), this Step #8 is repeatedly performed. On the other hand. In Step #8, if the front end of the PS plate 2 is judged to be detected (YES), a developing routine (Fig. 7) described later in Step #9 is triggered / performed, and then development treatment, water washing, and after-treatment are successively performed onto the PS plate 2. In this case, this development routine may be performed during the course of exposure routine. In this way, when the development routine is triggered and performed, the main routine comes to an end.

Description for printing routine as shown in Fig. 5 follows below: When the printing routine is triggered, plate position control is started in Step #11, and the PS plate 2 is gradually fed downward by a plate position control roll 5 (plate position control means).

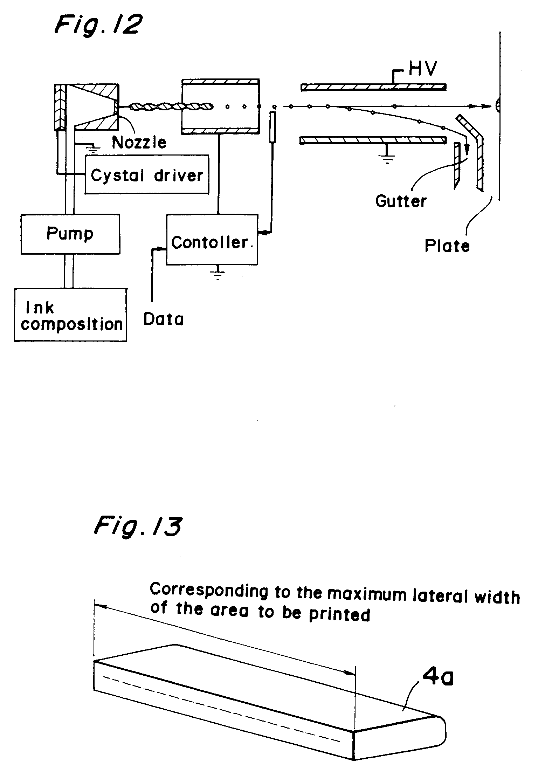

In Step #12, the area to be printed of the PS plate 2 is compared / judged to be or not to be in agreement with the position which corresponds to the printing position, namely, an ink jet head 4, and if judged to be not in agreement with the printing position (NO), Step #11 - Step #12 are repeatedly performed. On the other hand, if the area to be printed of the PS plate 2 in the Step #12 is judged to be in agreement with the printing position (YES), printing by the use of ink jet system is performed by injecting ink onto PS plate surface from the ink jet head 4 in Step #13. For the ink jet system, a drop on demand type as shown in Fig. 11, or a conventional ink jet system of load controlling continuous type as shown in Fig. 12 are used, for example. Likewise, as is not shown in figure, a bubble jet type may be acceptable.

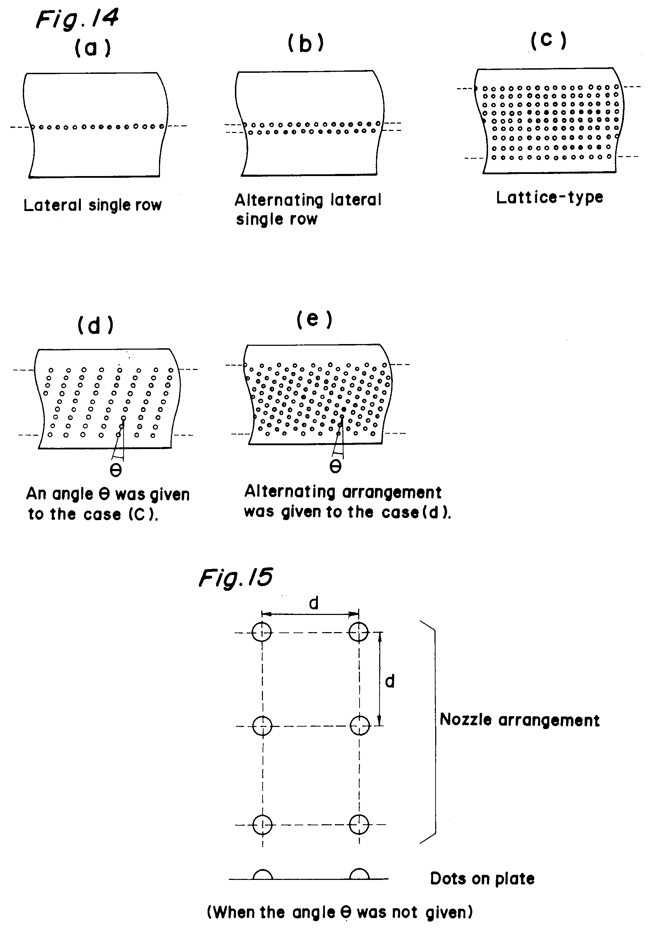

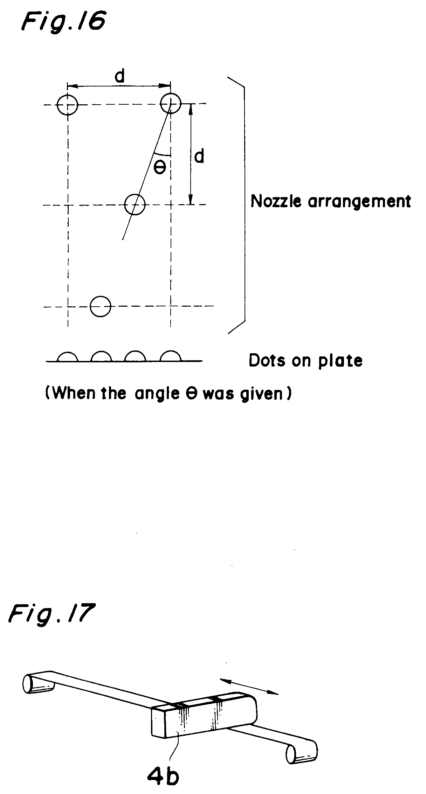

As an ink jet head 4, for example, a fixed type ink jet head 4a having a lateral width which corresponds to the maximum lateral width of the PS plate 2 is used, the rough sketch of which is shown in Fig. 13. Concrete examples of nozzle arrangement of such a fixed type ink jet head 4a are shown in Fig. 14 (a) - Fig. 14 (e). Here, in the nozzle arrangement as shown in Fig. 14 (d) and (e), each nozzle line is inclined by an angle $\theta$ to the advancing direction of the PS plate 2. With this nozzle arrangement thus inclined, the total number of dots to be typed per one line (possible number of dots) can be increased. For example, when the closest distance between nozzles possible to process is assumed to be d, possible number of dots are shown in Fig. 15 and Fig. 16, respectively, when the nozzle arrangement is not inclined and when it is inclined. As is apparent from these figures, the possible number of dots per one line increases remarkably when the nozzle arrangement is inclined by an angle $\theta$. In this case, in order to increase the possible number of dots to the maximum, it is sufficient to set the inclined angle $\theta$ so that the following formula 1 will be satisfied.

$$\tan \theta = ( 2r / d ) \qquad \text{Formula 1}$$

Here, r stands for a radius of nozzle in the formula 1.

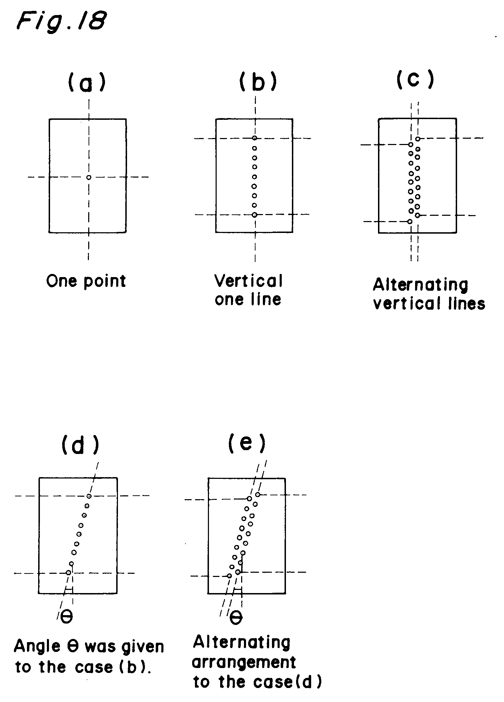

Likewise, as an ink jet head 4, a scanning type ink jet head 4b as shown in Fig. 17 may be acceptable. Concrete examples of nozzle arrangement of such a scanning type ink jet head 4b are shown in Fig. 18 (a) - Fig. 18 (e). In this connection, with the arrangement as shown in Fig. 18 (d) and (e), nozzle lines are inclined by an angle $\theta$ to the advancing direction of the PS plate 2. With the nozzle heads thus inclined, in the same manner as with the aforementioned fixed type ink jet head 4a, the possible number of dots per one line can be increased.

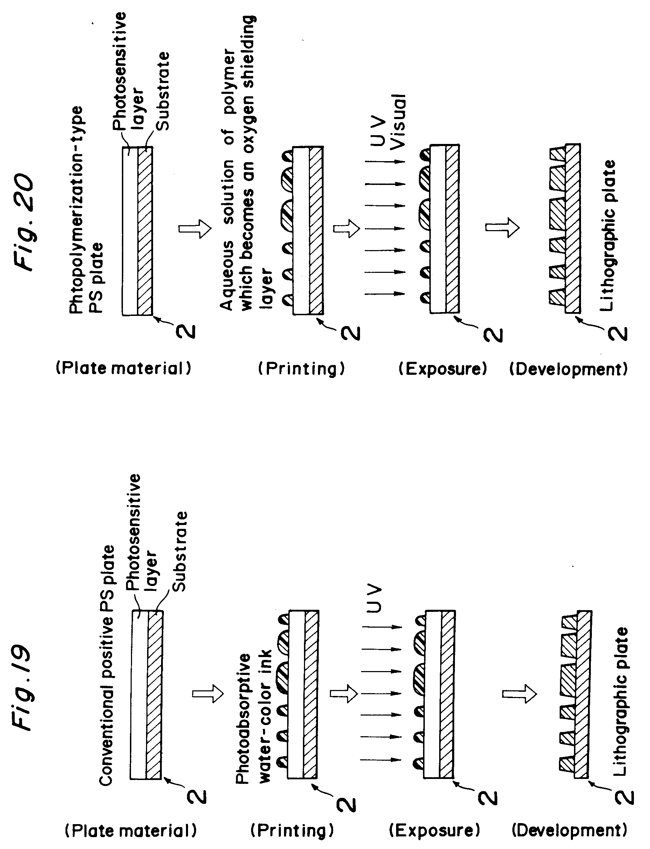

As to the composition of ink, for example, following compositions are used. (1) In case the PS plate 2 is of a positive-type PS plate, it's preferable to use a photoabsorptive water-based ink composition. The preferable concrete example of such a photoabsorptive water-based ink composition is disclosed in the Japanese patent application No. 296516 (year of 1990) filed in the name of the assignee of this United States application. In this case, the plates are produced by conducting a conventional light irradiation (exposure treatment) and development treatment after forming ink images with the photoabsorptive ink in accordance with the image data on the surface of PS plate 2 to be printed as shown in Fig. 19. Here, the photoabsorptive water-based ink composition is composed of a water-dispersible or water-soluble dye having absorption in a photosensitive wavelength range and a volatility inhibitor for preventing drying and agglomeration in the ink jet head 4 (inside the nozzle), its surface tension is adjusted so that preferable printing quality can be obtained when printing on the PS plate 2.

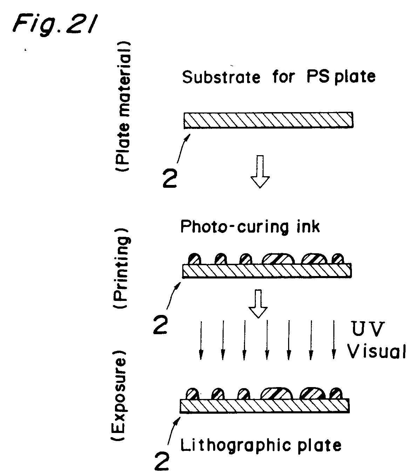

(2) In case the PS plate is of a photopolymerization type, it is preferable to use a water-based ink composition which contains water soluble polymer which becomes an oxygen shielding layer. As water-based ink composition, for example, a mixture of water soluble polymer like polyvinyl alcohol, etc., water miscible solvent like alcohols, surface active agent like polyethyleneglycolnonylphenylether, etc., and volatility inhibitor like polyethylene glycol is used. In this case, printing plate is produced by conducting a conventional light irradiation (exposure treatment) and a developing treatment after forming an ink image with a water-based ink composition which contains water soluble polymer in accordance with the image data on the PS plate 2 by using as an image layer a photopolymerizable composition to be printed as shown in Fig. 20. Here, a water-based ink composition is consisting of water-soluble or water dispersible polymer which becomes an oxygen shielding layer of the PS plate 2, and, as necessary, a volatility inhibitor which prevents drying and agglomeration in the ink jet head 4 (inside the nozzle) and an surface active agent which coordinates surface tension in order to obtain a preferable printing quality when printing on the PS plate 2 are added. In this connection, as will be described later, a plate making process is shown in Fig. 21 (second embodiment) in case a substrate for PS plate is used as plate material and a photocuring ink composition as ink composition. As photocuring ink composition, for example, a composition of which main components are of the compound capable of radical polymerization having an ethylenically unsaturated double bond and a radical polymerization initiator, and a composition of which main components are of the compound capable of cationic polymerization having a glycigyl group in the molecule are used. In addition to this, in the same manner as other ink compositions, a volatility inhibitor to prevent drying and agglomeration in the ink jet head 4 (inside the nozzle) is added as necessary, and then its surface tension is adjusted so that preferable printing quality can be obtained when printing on the substrate of PS plate. In this case, having a higher ratio of nonvolatile components and lower viscosity is preferable for this photocuring ink composition.

In Step #14, a comparison / judgment is made as to whether image data to be printed is completed or not, and if judged that the image data to be printed has not been completed (NO), Step #11 - Step #14 are repeatedly performed. In this way, ink images which correspond to the image data are formed on the surface of the PS plate 2 in order. In this case the position of the PS plate 2 is accurately controlled by the plate position control roll 5 (plate position control means), and accurate ink images are formed on the surface of the PS plate 2. If the ink jet head 4 is of a scanning type, the ink jet head 4 is accurately scanned by a printing head driver, and accurate ink images are formed on the surface of the PS plate 2.

On the other hand, if printing data are judged to be completed in Step #14 (YES), printing is completed in Step #15, and a printing routine comes to an end.

Description for an exposure routine shown in Fig. 6 follows below. When the exposure routine is triggered, a light having emission line spectrums which complies with the characteristics of a photosensitive layer or ink composition is irradiated onto the PS plate 2 from an image exposure light source 7 in Step #21, and an exposure treatment is triggered. With this exposure treatment, the following chemical change will occur to the PS plate 2 on which ink images are formed.

(1) When the PS plate 2 is of a positive type, and the ink composition is of a photoabsorption water-based ink composition, essentially a photosensitive layer which is non-soluble in the developer changes into a substance which shows solubility to the developer in an area where ink images are not formed in the following manner; the light is first irradiated directly onto the photosensitive layer on the PS plate 2, then the main chain of polymer which constitutes a photosensitive layer is cut off by light energy and then made into a low molecular, or given rise to a water soluble carboxyl group. On the other hand, in an area where the ink image is formed, the light irradiated is absorbed in the ink images and so the light does not reach the photosensitive layer, making chemical reactions impossible and thus retaining insolubility to the developer in the photosensitive layer.

(2) When the PS plate 2 is of a photopolymerization type, and the ink composition is of a water-based ink composition containing an water soluble high polymer which becomes an oxygen shielding layer, fundamentally a photosensitive layer which is soluble in the developer becomes hardened and then changes into a substance which shows insolubility to the developer in an area where ink images are formed in the following manner; the light which passed through the ink images first irradiated onto the photosensitive layer, then with radicals generated therewith the polymerization is generated in a chain-like manner. On the other hand, in an area where the ink image is not formed, the photosensitive layer retains solubility to the developer because the progress of polymerization in a chain-like manner is retarded by oxygen contained in the air.

Therefore, for all the cases above, the area where the ink images are formed becomes insoluble in the developer, while the area where the ink images are not formed becomes soluble.

In Step #22, it is so designed that a comparison / judgment is made as to whether the rear end of the PS plate 2 is detected or not by the third plate position detecting means S3 arranged directly downward to the image exposure means, namely, as to whether the whole of the PS plate 2 is transferred from the image exposure section C, and then the light irradiation became unnecessary. And, if judged to be not detected (NO), Step #21 - Step #22 are repeatedly performed. On the other hand, if the rear end of the PS plate 2 is judged to be detected (YES) in Step #22, light irradiation from the image exposure light source 7 is stopped in Step #23, and the exposure routine is completed.

Description for the development routine as shown in Fig. 7 follows below. In this case, with this development routine, a development treatment, water washing treatment, and after-treatment are conducted to the PS plate 2. When development routine is started, first of all, developer is supplied onto the surface of the PS plate 2 from a developer supply nozzle 9 (developer supply means) in Step #31, and a rotary brush 10 (mechanical development means) is rotated, and the development treatment is started. In this development treatment, a soluble area where ink images of photosensitive layer are not formed, i.e., unnecessary photosensitive layer is swelled and/or dissolved through contact with the developer and then removed from the surface of the PS plate 2 by scraping with the rotary brush 10. On the other hand, ink images are eliminated in an area where ink images are formed, but the photosensitive layer remains as it was, because the layer is insoluble in the developer. That is, on the surface of the PS plate, only an area where ink images are formed is left and this very area becomes an image area of a printing plate (see Fig. 19 and Fig. 20).

This development treatment continues until the time t2, through which development treatment section D is required to pass, is elapsed after start of the development treatment. However, after start of the development, water washing treatment is performed in parallel with the development treatment after the time t1 (t1<t2), through which the PS plate 2 reaches up to the water washing treatment section E, has elapsed.

That is, a comparison / judgment is made as to whether time t1 has elapsed or not after start of the development treatment, and if judged to be elapsed by the time t1 (YES), washing water is supplied onto the surface of the PS plate 2 from a water washing nozzle 11 (plate washing means), and then water washing treatment is started. On the other hand, if judged to be elapsed by the time t1 (NO), Step #33 is skipped.

Following this, at Step #34, after start of the development, a comparison / judgment is made as to whether the time t2 has elapsed or not. Here, if judged that the time t2 has not elapsed (NO), Step #31 - Step #34 are repeatedly performed, and if judged that the time t2 has elapsed (YES), supply of developer and washing water are stopped at Step #35, and also the rotation of the rotary brush 10 is stopped, and finally development and water washing treatments are simultaneously completed. In this case, the time t2 is indeed designed to be set so that the rear end of the PS plate 2 can pass through the water washing treatment section E.

In this case, instead of completing the water washing treatment at the same time along with the development treatment in such a way, the water washing treatment may be completed when the passing of the rear end of PS plate 2 is detected by this plate position detecting means, by providing the plate position detecting means which detects the passing of the rear end of PS plate 2, directly downward to the water washing treatment section E. Or, the water washing time may be independently set apart from the development treatment time.

After completing the development and water washing treatments in this way, at Step #36 a comparison / judgment can be made as to whether the front end of the PS plate 2 is detected or not by the fifth plate position detecting means S5 arranged directly upward to a desensitization liquid supply nozzle 12 (after-treatment application means), and if judged to be not detected (NO), this Step #36 is repeatedly performed. On the other hand, if judged that the front end of the PS plate 2 is detected (YES), the after-treatment is performed to the PS plate 2 at Step #37. That is, desensitization liquid is supplied to the surface of the PS plate 2 from an desensitization liquid supply nozzle 12, and then excessive desensitization liquid on the surface of the PS plate is removed by an excessive desensitization liquid elimination roll 13. Following this, drying treatment is performed to the PS plate 2 by the drying area 14, solvent constituent in the desensitization liquid on the PS plate surface is evaporated, and then the desensitization constituent is fixed on the PS plate surface. In this case, the drying temperature is controlled by a drying temperature control means.

At Step #38, a comparison / judgment is made as to whether after start of the after-treatment a predetermined time t3 has elapsed or not, and if judged that the time t3 has not elapsed (NO), Step #37 - Step #38 are repeatedly performed. On the other hand, if judged that the time t3 has elapsed (YES), supply of the desensitization liquid is stopped at Step #39, and the after-treatment is completed.

The printing plate which is completed by being performed with the after-treatment, is taken out of the plate discharge section 8. According to the first embodiment above, the printing plate excellent for printing durability and resolution can be produced based on the digital image information even if the sensitivity of the plate material is comparatively lower, without using any film. In addition, the plate making apparatus is made compact, also allowing a plate making process to be made simple.

<Second Embodiment>

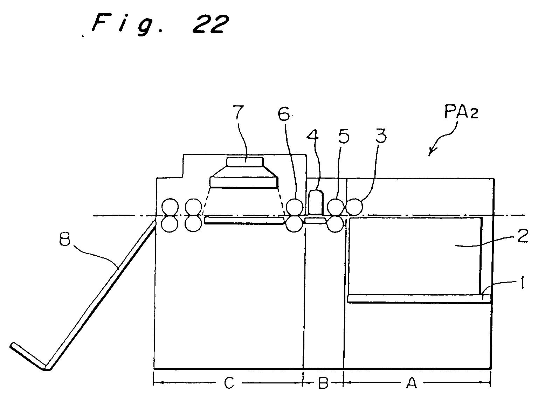

Description follows below of the second embodiment of which plate material is mainly of a substrate without a photosensitive layer. But, in order to avoid duplication of description, same numbers as in the first embodiment are given to any sections which are common with the first embodiment shown in Fig. 3 and so description was omitted, and description follows only on different points from the first embodiment. As shown in Fig. 22, in the second embodiment, the plate making apparatus PA2 is essentially consisting of plate feeding section A, image output section B, and image exposure section C, but the development treatment section, water washing treatment section, and after treatment section as seen in the first embodiment are not provided. Except this point, the plate making apparatus PA2 is structured in almost the same way as the plate making apparatus PA1 of the first embodiment.

In the second embodiment, the conventional substrate for the PS plate is used as plate material 2. In this case, as an ink composition to form ink images on the plate material 2, for example, a photocuring ink composition is used. And, as shown in Fig. 21, an ink image is formed on the plate material 2 (substrate) to be printed with a photocuring ink composition in accordance with image data, followed by an exposure treatment from which the ink image is hardened, and this hardened ink image directly becomes an image area, and finally printing plate is completed. In this connection, in order to improve the bonding strength between the photocuring ink composition and plate material 2, or to obtain preferable printing quality, a primer layer may be provided on the plate material 2. In this case, it is preferable that such a primer layer has sufficient hydrophilicity on the surface upon printing or can be removed upon printing. However, if not, it may be removed by providing after exposure the development treatment section D or the water washing section E as shown in the first embodiment. Furthermore, when an exposure-treated plate requires, for example, an after-treatment such as desensitization, it may be preferable to conduct an after-treatment by providing the after-treatment section F as shown in the first embodiment. Even in case of the second embodiment, based on digital image information, the printing plate with excellent printing durability and resolution can be produced without using film.

<Third embodiment>

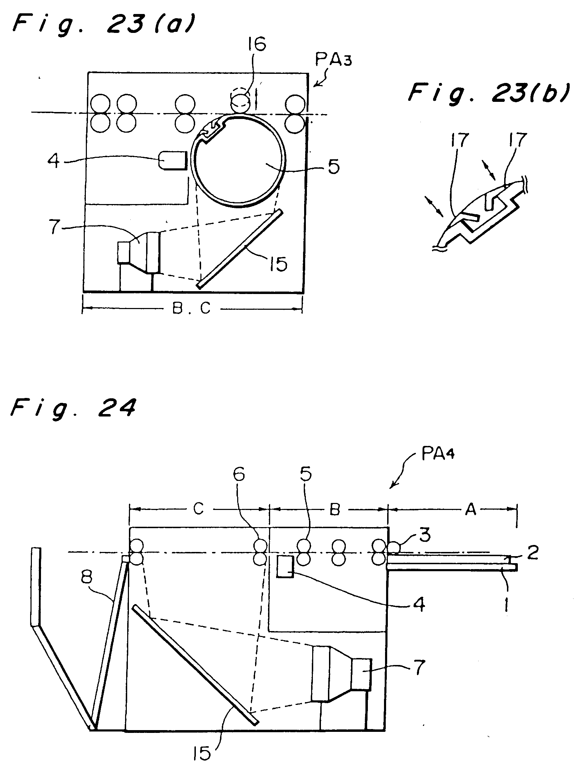

Description follows below of the third embodiment of the present invention by referring to Fig. 23 (a) and (b), however, in order to avoid unnecessary duplication, for common section to the first embodiment as shown in Fig. 3, same numbers as used in the first embodiment are attached for omitting their description, thus only different points from the first embodiment are described. As shown in Fig. 23 (a) and (b), the image output section B and the image exposure section C in the plate making apparatus PA3 in the third embodiment are unified. The plate material (PS plate or substrate) fed from the plate feeding area (not shown) is so designed that it is fastened around the plate position control roll 5 of rotary drum type. Here, loading of plate material to the plate position control roll 5 is effected by a pinch roll 16 which is movable in an upward / downward direction and a gripping claws 17 provided on a part of the plate position control roll 5. And, exposure treatment is performed by the light which is irradiated through a reflection mirror 15 from an image exposure light source 7, by rotating the plate position control roll and also forming the ink images on the surface of plate material by an ink jet head 4. After the printing and the exposure treatment are completed, when the plate material is of the PS plate, further development and water washing treatments, and after-treatment are followed hereafter. If the plate material is of a substrate, printing plate is completed with the above treatment. With the third embodiment, the plate making apparatus PA3 is made compact, because the image output section B and image exposure section C can be made integrally.

<Fourth embodiment>

Description of the fourth embodiment of the present invention follows below by referring to Fig. 24, however, in order to avoid unnecessary duplication, for a common area to the first embodiment as shown in Fig. 3, same numbers as used in the first embodiment are attached for omitting their description, thus only different points from the first embodiment are described. As shown in Fig. 24, in the fourth embodiment, the ink jet head 4 is arranged under the plate material 2 in the image output section B. Likewise, in the image exposure section C, an image exposure light source 7 is arranged under the plate material 2. Therefore, it is so designed that ink images are formed on the surface of the plate material by the ink jet head 4, then light is irradiated on the surface of the plate material 2 through a reflection mirror 15 from the image exposure light source 7, and so exposure treatment is performed. According to the fourth embodiment, because the ink jet head 4, image exposure light source 7 and the like are arranged inside the housing of the apparatus, the plate making apparatus PA4 can be made compact.

<Fifth embodiment>

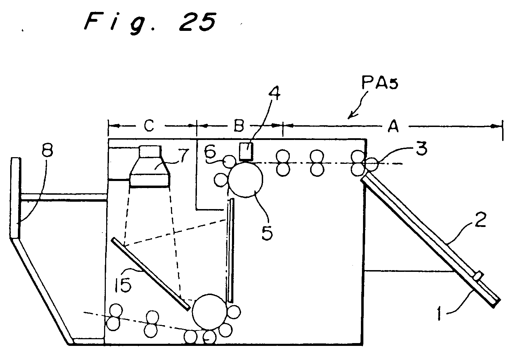

Description follows below of the fifth embodiment of the present invention by referring to Fig. 25, however, in order to avoid unnecessary duplication for a common area to the first embodiment as shown in Fig. 3, same numbers as used in the first embodiment are attached for omitting their description, thus only different points from the first embodiment are described. As shown in Fig. 25, in the fifth embodiment, the loading surface of a plate feeding base 1 in the plate feeding section A on the plate making apparatus PA5 is inclined. And, it is so designed that in the image exposure section C, plate material is first fed downward, at which time light is irradiated through a reflection mirror 15 from an image exposure light source 7, and then the light is irradiated to the surface of the plate material 2 from a lateral direction. After completing the exposure, the plate material 2 is fed to a discharge area 8 through the neighborhood of lower end of the image exposure section C. According to the fifth embodiment, because the image exposure light source 7 and the like are arranged inside the housing of the apparatus, the plate making apparatus PA5 can be made compact.

[Operation and Effects of the Invention]

According to the first invention, printing plate is produced in such a manner that an ink image is first formed on the surface of plate material by an ink jet system, and with exposure treatment an image area is then formed directly on the surface of the plate material. Therefore, the printing plate can be produced in accordance with the digital image information transferred from computer, facsimile and the like without using films. And, since the image output means of ink jet system can be made compact as well as inexpensive compared with the laser apparatus, etc., thus allowing the plate making apparatus to be made compact and lower in cost. In addition to this, the plate making process itself can be made simple.

According to the second invention, printing plate is produced in such a manner that the ink image is first formed on the surface of the plate material by the image output means, and then an exposure treatment, etc. are conducted by printing area forming means, and finally the image area is directly formed on the surface of the plate material. Therefore, based on the digital image information transmitted from computer, facsimile and the like, printing plate can be made without using films. And, since the image output means by use of ink jet system is compact and inexpensive, thus allowing the plate making apparatus to be made compact and lower in cost. In addition to this, the plate making process itself can also be made simple.

## Claims

1. Direct lithographic plate making method using an ink jet system, comprising steps of; feeding a plate material to a plate making apparatus, forming an ink image corresponding to the image information directly onto the surface of plate material, and forming an image area on the plate material by exposing the surface of plate material.

2. Lithographic plate making apparatus, comprising; plate feeding means for feeding a plate material, image output means of an ink jet system for forming an ink image directly onto the surface of plate material based on image information, and image area forming means for forming an image area on the plate material by exposing the surface of plate material on which the ink image has been formed.

## Fig. 1

| Substrate for PS Plate or lithographic plate |
|---|

| plate feeding section | A |
| Image output section | B |
| Image exposure section | C |
| Development treatment section | D |
| Water washing section | E |
| After-treatment section | F |

| Lithographic plate | Lithographic plate |
|---|---|
| ( PS plate ) | ( Substrate ) |

Fig.2

Fig. 3

*Fig.4*

START

Image data read-in #1

Read or complete? #2
NO / YES

Plate feeding #3

Is plate front end $S_1$ position? #4
NO / YES

Printing routine execution #5

Is plate front end $S_2$ Position? #6
NO / YES

Exposure routine execution #7

Is plate front end $S_4$ position? #8
NO / YES

Development routine execution #9

END

*Fig.5*

```
        START
          |
   ┌──────────────┐
   │ Plate position│  #11
   │   control     │
   └──────────────┘
          |
        /      \
 NO  / Printing  \   #12
 ◄──< Position    >
      \          /
        \      /
          | YES
   ┌──────────────┐
   │   Printing    │  #13
   └──────────────┘
          |
        /      \
 NO  /   Data    \   #14
 ◄──< Printing    >
      \ complted?/
        \      /
          | YES
   ┌──────────────┐
   │Printing complete│  #15
   └──────────────┘
          |
        END
```

*Fig.6*

```
        START
          |
   ┌──────────────┐
   │   Exposure    │  #21
   └──────────────┘
          |
        /      \
 NO  / Is plate  \   #22
 ◄──< rear end S3 >
      \ position?/
        \      /
          | YES
   ┌──────────────┐
   │   Exposure    │  #23
   │   complete    │
   └──────────────┘
          |
        END
```

*Fig. 7*

```
                    ┌─────────────┐
                    │    START    │
                    └──────┬──────┘
                           │
   ┌──────────────────────►│
   │            ┌──────────────────────┐
   │            │     Development       │  #31
   │            └──────────┬───────────┘
   │                       │
   │                      ╱ ╲              #32
   │                    ╱     ╲
   │                  ╱   Has   ╲    NO
   │                 ╱  time t₁   ╲──────────┐
   │                 ╲  elapsed? ╱           │
   │                   ╲       ╱             │
   │                     ╲   ╱               │
   │                      ╲ ╱ YES            │
   │            ┌──────────────────────┐     │
   │            │    Water washing      │ #33 │
   │            └──────────┬───────────┘     │
   │                       │◄────────────────┘
   │                      ╱ ╲
   │           NO       ╱     ╲              #34
   │  ┌───────────────╱   Has   ╲
   │  │               ╲  time t₂ ╱
   │  │                ╲ elapsed?╱
   │  │                  ╲     ╱
   │  │                    ╲ ╱ YES
   │  │          ┌──────────────────────┐
   │  │          │ Development/water     │ #35
   │  │          │ washing completed     │
   │  │          └──────────┬───────────┘
   │  │                     │
   │  │        ┌───────────►│
   │  │        │           ╱ ╲             #36
   │  │        │    NO    ╱     ╲
   │  │        └────────╱  Is plate ╲
   │  │                 ╲ front end S₅╱
   │  │                  ╲ position? ╱
   │  │                    ╲       ╱
   │  │                      ╲   ╱ YES
   │  │          ┌──────────────────────┐
   │  │          │   After-treatment     │ #37
   │  │          └──────────┬───────────┘
   │  │                     │
   │  │                    ╱ ╲            #38
   │  │          NO      ╱     ╲
   │  │      ┌─────────╱   Has   ╲
   │  │      │         ╲  time t₃ ╱
   │  │      │          ╲ elapsed?╱
   │  │      │            ╲     ╱
   │  │      │              ╲ ╱ YES
   │  │      │    ┌──────────────────────┐
   │  │      │    │   After-treatment     │ #39
   │  │      │    │   completed           │
   │  │      │    └──────────┬───────────┘
   │  │      │               │
   │  │      │        ┌──────────────┐
   │  │      │        │     END      │
   │  │      │        └──────────────┘
```

Fig. 8

VAC.

Fig. 9

# F i g. 10

# Fig. 11

Transducer   Nozzle        Plate

Ink composition
(Atmospheric
pressure)          Data pulse train

## Fig. 12

HV

Nozzle

Cystal driver

Pump

Contoller.

Ink composition

Data

Gutter

Plate

## Fig. 13

Corresponding to the maximum lateral width of the area to be printed

4a

## Fig. 14

(a)

Lateral single row

(b)

Alternating lateral
single row

(C)

Lattice-type

(d)

θ

An angle θ was given
to the case (C).

(e)

θ

Alternating arrangement
was given to the case (d).

## Fig. 15

d

d

Nozzle arrangement

Dots on plate

(When the angle θ was not given)

## Fig./6

Nozzle arrangement

Dots on plate

(When the angle Θ was given)

## Fig./7

4b

## Fig. 18

**( a )**

One point

**( b )**

Vertical
one line

**( c )**

Alternating
vertical lines

**( d )**

Angle $\Theta$ was given
to the case ( b ).

**( e )**

Alternating
arrangement
to the case(d)

*Fig. 20*

Phtopolymerization-type PS plate

Photosensitive layer
Substrate

2

(Plate material)

Aqueous solution of polymer which becomes an oxygen shielding layer

2

(Printing)

UV
Visual

2

(Exposure)

Lithographic plate

2

(Development)

*Fig. 19*

Conventional positive PS plate

Photosensitive layer
Substrate

2

(Plate material)

Photoabsorptive water-color ink

2

(Printing)

UV

2

(Exposure)

Lithographic plate

2

(Development)

*Fig.21*

(Plate material)

Substrate for PS plate

2

(Printing)

Photo-curing ink

2

UV
Visual

(Exposure)

2 Lithographic plate

# Fig. 22

Fig. 23 (a)

Fig. 23(b)

Fig. 24

28

# Fig. 25

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN vol. 7, no. 245 (P-233)29 October 1983 & JP-A-58 132 236 ( DAINIPPON INSATSU KK ) 6 August 1983 * abstract * | 1,2 | G03F1/00 B41C1/10 |
| X | & WORLD PATENTS INDEX LATEST Week 3783, Derwent Publications Ltd., London, GB; AN 83-761939 & JP-A-58 132 236 (DAINIPPON PRINTING KK) 6 August 1983 * abstract * | 1,2 | |
| X | WORLD PATENTS INDEX LATEST Week 0291, Derwent Publications Ltd., London, GB; AN 91-012325 & JP-A-2 286 335 (MATSUSHITA ELEC IND KK) 26 November 1990 * abstract * | 1,2 | |
| X | PATENT ABSTRACTS OF JAPAN vol. 12, no. 343 (M-741)14 September 1988 & JP-A-63 102 936 ( CANON INC ) 7 May 1988 * abstract * | 1,2 | TECHNICAL FIELDS SEARCHED (Int. Cl.5 ) G03F B41C |
| X | PATENT ABSTRACTS OF JAPAN vol. 5, no. 187 (M-098)26 November 1981 & JP-A-56 105 960 ( FUJI PHOTO FILM CO. LTD. ) 22 August 1981 * abstract * | 1,2 | |
| X | PATENT ABSTRACTS OF JAPAN vol. 12, no. 347 (M-743)19 September 1988 & JP-A-63 109 052 ( CANON INC ) 13 May 1988 * abstract * | 1,2 | |
| | -/-- | | |

The present search report has been drawn up for all claims

| Place of search | Date of completion of the search | Examiner |
|---|---|---|
| THE HAGUE | 25 JUNE 1992 | D. Hillebrecht |

EPO FORM 1503 03.82 (P0401)

European Patent
Office

EUROPEAN SEARCH REPORT

Application Number

EP    92 10 4270
Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN<br>vol. 10, no. 40 (M-454)18 February 1986<br>& JP-A-60 192 693 ( TORAY KK ) 1 October 1985<br>* abstract * | 1,2 | |
| X | & WORLD PATENTS INDEX LATEST<br>Week 4585,<br>Derwent Publications Ltd., London, GB;<br>AN 85-280995<br>& JP-A-60 192 693 (TORAY IND INC) 1 October 1985<br>* abstract * | 1,2 | |
| | ----- | | |
| | | | TECHNICAL FIELDS SEARCHED (Int. Cl.5 ) |

The present search report has been drawn up for all claims

| Place of search | Date of completion of the search | Examiner |
|---|---|---|
| THE HAGUE | 25 JUNE 1992 | O. Hillebrecht |